Europäisches Patentamt

European Patent Office

Office européen des brevets

(11) Publication number: **0 334 365**
**A2**

(12) **EUROPEAN PATENT APPLICATION**

(21) Application number: **89105265.6**

(22) Date of filing: **23.03.89**

(51) Int. Cl.⁴: **H05K 5/02**

(30) Priority: **25.03.88 JP 71349/88**

(43) Date of publication of application:
**27.09.89 Bulletin 89/39**

(84) Designated Contracting States:
**AT BE CH DE ES FR GB IT LI NL SE**

(71) Applicant: **Schaltbau Gesellschaft mbH**
**Klausenburger Strasse 6**
**D-8000 München 80(DE)**

(72) Inventor: **Shiraishi, Takayuki**
**No. 21-17 Takashima 1-chome**
**Suwa-shi Nagano(JP)**
Inventor: **Uchiyama, Teruo**
**No. 21-17 Takashima 1-chome**
**Suwa-shi Nagano(JP)**

(74) Representative: **Patentanwälte Grünecker,**
**Kinkeldey, Stockmair & Partner**
**Maximilianstrasse 58**
**D-8000 München 22(DE)**

(54) **Housing case for electromechanical equipment.**

(57) A housing case for electromechanical equipment, comprising a body and a cover mounted on the body, characterized in that:
a slant face is formed on said body between two sides adjacent mutually, and an electric wire connection is provided on the slant face;
said cover has two sides symmetrically in contour outline which correspond to a deficient portion due to the slant face of said body, has an electric wire hole for inserting an electric wire to be connected to said electric wire connection formed on one side of the two, and is mounted on said body to cover the slant face.

FIG.1

## HOUSING CASE FOR ELECTROMECHANICAL EQUIPMENT

Description of the invention

This invention relates to a housing case for electromechanical equipment, and is particularly concerned with a housing case for electromechanical equipment through which to connect electric wires such as power cord, incoming/outgoing signal line and the like.

In electromechanical equipment such as photoelectric switch, OA equipment, AV equipment and the like, an external wire is extracted, in most cases, through an electric wire hole provided on the back of a housing case hitherto.

(Problem to be Solved by the Invention)

In the aforementioned construction wherein an electric wire is extracted from the back of the housing case, the electric wire is rather obstructive and is an impediment above all when the equipment is installed close to wall surface or the like.

An object of the invention is therefore to make the direction in which the electric wire is extracted ready for changing when electromechanical equipment is installed.

(Means to Solve the Problem)

The invention comprises a housing case for electromechanical equipment consisting of a body and a cover mounted on the body, wherein a slant face is formed on the body between two sides adjacent mutually, and an electric wire connnection is provided on the slant face, the cover has two sides symmetrically in contour outline which correspond to a deficient portion due to the slant face of the body, has an electric wire hole for inserting an electric wire to be connected to the electric wire connection formed on one side of the two, and is mounted on the body to cover the slant face.

In the invention, an electric wire is connected to the electric wire connection on the slant face of the body. the electric wire is inserted in an electric wire hole on the cover, and then the cover is installed on the body to cover the slant face. In this case, the electric wire hole is disposed on one side of the adjacent two of the body by inverting the cover, thereby selecting the direction in which the electric wire is extracted.

The invention will now be described with reference to the accompanying drawings representing one preferred embodiment thereof.

Brief Description of the Drawings

Fig. 1 is a side view, partly cutaway, representing a housing case for electromechanical equipment given in one embodiment of the invention;

Fig. 2 is a view showing a lower portion of the slant face of a body of Fig. 1;

Fig. 3 and Fig. 4 are side views showing a state of installation;

Fig. 5 is a perspective view representing another embodiment of the invention.

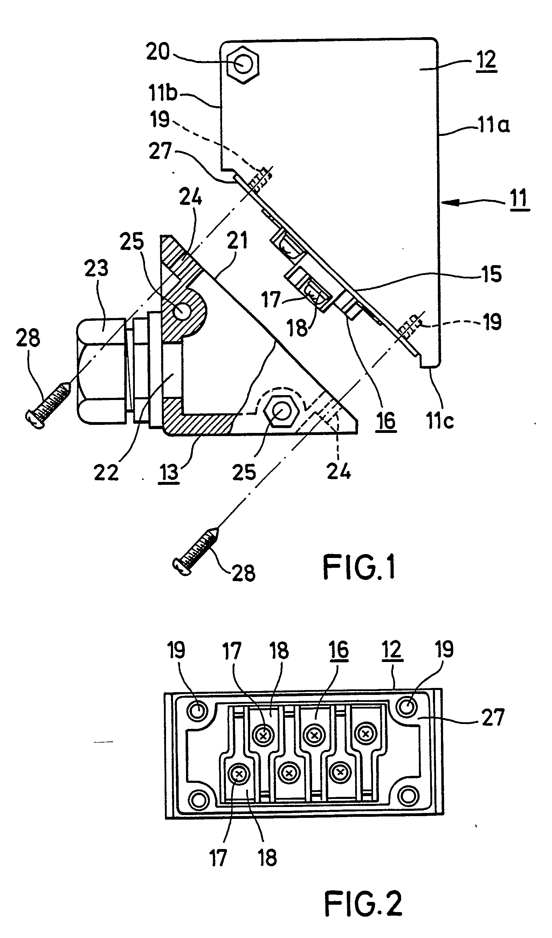

Fig. 1 to Fig. 4 represent electromechanical equipment such as photoelectric switch and the like.

A reference numeral 11 denotes a housing case, and the housing case 11 is a rectangular parallelopiped elongated vertically as a whole, comprising a body 12 and a cover 13 mounted on the body 12 as a back.

A slant face 15 is formed on the body 12 by removing a portion like a right-angled isosceles triangle between two sides adjacent mutually, i.e. covering a lower portion of a back face 11b counter to a front face 11a of the housing case 11 to a lower face 11c adjacent thereto, and an electric wire connection 16 is provided on the slant face 15. A plurality of terminals 18 having a terminal screw 17 each are disposed on the electric wire connection 16. Then, a tapped hole 19 is formed on opposite end portions of the slant face 15. Further, a tapped hole 20 is formed in the rear of a side face of the body 12.

The cover 13 takes a shape of having two sides corresponding to a deficient portion due to the slant face 15 of the body 11 symmetrically in contour outline viewed from the side, that is, the contour outline is shaped like a right-angled isosceles triangle including a lower portion of the back face 11b of the housing case 11 and the lower face 11c, the side of a slant face 21 corresponding to the slant face of the body 12 is open, an electric wire hole 22 is formed on one side of orthogonal faces, and an electric wire bush 23 for preventing drop incoming is mounted on an outside of the electric wire hole 22. Then, a coupling hole 24 corresponding to the tapped hole 19 is formed near opposite ends of the orthogonal faces. Further, a tapped hole 25 is formed on a lower portion and in the rear of the side faces of the cover 13.

For installation, electric wires such as power cord, incoming/outgoing signal line and the like are connected to each terminal 18 of the body 12, and

2

the wires are inserted in the electric wire hole 22 of the cover 13 through the electric wire bush 23.

Next, the slant face 21 of the cover 13 is fitted to the slant face 15 of the body 12 through a sealing material 27 such as rubber or the like, a screw 28 is fastened in the tapped holes 19 through each hole 24, the slant face 15 of the body 12 is covered with the cover 13 and thus the cover 13 is fixed on the body 12.

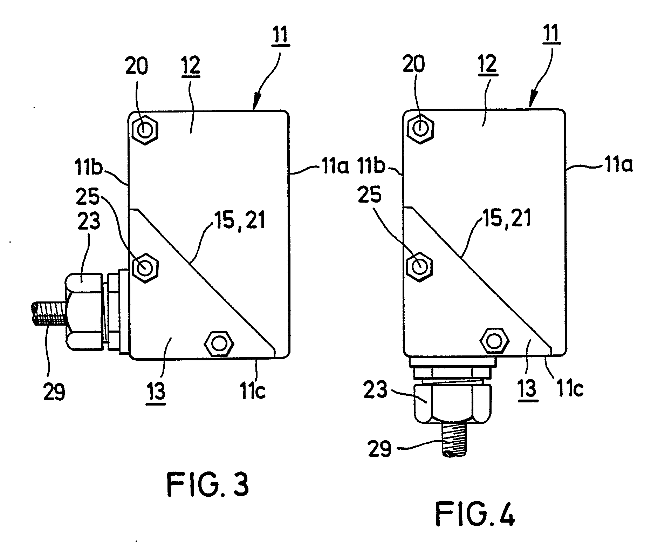

In this case, as shown in Fig. 3, an electric wire 29 can be derived rearward by mounting the cover 13 with the electric wire hole 22 coming rearward, and as shown in Fig. 4, the electric wire 29 can be derived downward by mounting the cover 13 inversely with the electric wire hole 22 coming downward.

Then, a contour outline of the cover 13 is shaped like a right-angled isosceles triangle and hence is symmetrical with reference to a line connecting the vertical angle portion and a midpoint of the slant face 21, and if the cover 13 is replaced with the slant face 21 upside-down, the contour does not change but only a position of the electric wire hole 22 changes, therefore the direction in which the electric wire is extracted can be changed as described from shaping the cover 13 like a right-angled isosceles triangle or approximate thereto.

Then, the housing case 11 is mounted on an external support member by means of the tapped holes 20, 25 of the body 12 and the cover 13.

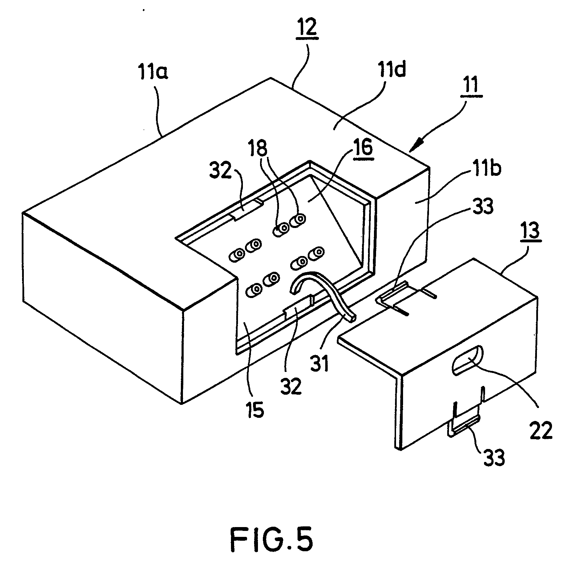

Next, another embodiment of the invention will be described with reference to Fig. 5.

Fig. 5 represents electromechanical equipment such as audio amplifier or the like.

In this case, the housing case 11 is a rectangular parallelopiped elongated horizontally as a whole, the slant face 15 is formed on the body 12 by removing a portion of right-angled isosceles triangle covering an intermediate zone between the back face 11b of the housing case 11 and the rear of a top face 11d adjacent thereto, a plurality of plug-in type terminals 18 are disposed on the electric wire connection 16 of the slant face 15, and a power cord 31 is connected thereto beforehand. Further, an engaging part 32 is formed on central upper and lower portions of the slant face 15.

Then, the cover 13 takes a shape of having two sides corresponding to a deficient portion due to the slant face 15 of the body 11 symmetrically in contour outline viewed from the side, that is, the contour outline is shaped like a right-angled isosceles triangle including the back face 11b of the housing case 11 and the rear of the top face 11d, however, opposite side plates for forming the slant face are not particularly provided, which is shaped like "L". The electric wire hole 22 is formed on one of the orthogonal faces of the cover 13, and an engaging claw 33 corresponding to the engaging part 32 is provided protuberantly in an intermediate zone between opposite ends.

For use, meanwhile, electric wires other than the power cord 31 such as incoming/outgoing signal line and others are connected to each terminal 18 of the body 12, and the power cord 31 and other wires are inserted through the electric wire hole 22 of the cover 13.

Then, the cover 13 is disposed on the slant face 15 of the body 12, the engaging claw 33 is inserted in each engaging part 32, the slant face 15 of the body 12 is covered with the cover 13, and thus the cover 13 is fixed on the body 12.

In this case, the electric wire can be derived rearward from mounting the cover 13 with the electric wire hole 22 coming rearward, and the electric wire can also be derived upward from mounting the cover 13 inversely with the electric wire hole 22 coming upward.

According to the invention, the direction in which the electric wire is extracted can be changed and so selected by inversion of the cover, accordingly the equipment can be arbitrarily installed and used without being regulated by the direction in which the electric wire is extracted.

## Claims

(1) A housing case for electromechanical equipment, comprising a body and a cover mounted on the body, characterized in that:
a slant face is formed on said body between two sides adjacent mutually, and an electric wire connection is provided on the slant face;
said cover has two sides symmetrically in contour outline which correspond to a deficient portion due to the slant face of said body, has an electric wire hole for inserting an electric wire to be connected to said electric wire connection formed on one side of the two, and is mounted on said body to cover the slant face.

FIG.1

FIG.2

FIG. 3

FIG. 4

FIG.5